(19) Europäisches Patentamt
European Patent Office
Office européen des brevets

(11) **EP 4 741 839 A1**

(12) **EUROPEAN PATENT APPLICATION**

(43) Date of publication:
**13.05.2026 Bulletin 2026/20**

(21) Application number: **25205562.9**

(22) Date of filing: **30.09.2025**

(51) International Patent Classification (IPC):
*G01R 15/18* (2006.01)    *G01R 19/20* (2006.01)

(52) Cooperative Patent Classification (CPC):
**G01R 15/185;** G01R 19/20

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **06.11.2024 CN 202411577683**

(71) Applicant: **Honeywell International Inc.**
**Charlotte, NC 28202 (US)**

(72) Inventors:
• **LIU, Zhi**
**Charlotte, 28202 (US)**
• **SONG, Ting**
**Charlotte, 28202 (US)**
• **LI, Yangyang**
**Charlotte, 28202 (US)**
• **CHEN, Wu**
**Charlotte, 28202 (US)**
• **WANG, Jie**
**Charlotte, 28202 (US)**
• **HU, Yu**
**Charlotte, 28202 (US)**
• **GU, Jinxi**
**Charlotte, 28202 (US)**

(74) Representative: **Haseltine Lake Kempner LLP**
**Cheapside House**
**138 Cheapside**
**London EC2V 6BJ (GB)**

(54) **FLUXGATE CURRENT SENSOR**

(57) Embodiments of the present disclosure provide techniques for improved fluxgate current sensor. A fluxgate signal (120) corresponding to a primary current may be received. The fluxgate signal may include at least two plateau periods (210A, 210B). Each plateau period may define a plurality of candidate calculation windows (330A). An operation condition classification may be generated based on a signal characteristics set by applying the signal characteristics set to a classification model. The operation condition may be one of an AC operation condition or DC operation condition. A calculation window may be selected based on the operation condition classification. The plurality of calculation windows may include a first calculation window and a second calculation window. A predicted current value may be generated for the primary current by applying sampled current values within the selected calculation window for each of the at least two plateau periods to a prediction model.

FIG. 1

**Description**

**FIELD OF THE INVENTION**

The present disclosure relate to current sensors and, more particularly, to fluxgate current sensor measurement. Some example embodiments are directed to fluxgate current sensor under alternating current operation.

**BACKGROUND**

Applicant has identified many technical challenges and difficulties associated with current sensor measurement. Through applied effort, ingenuity, and innovation, Applicant has solved many of these identified problems by developing the embodiments of the present disclosure, which are described in detail below.

**BRIEF SUMMARY**

Various embodiments described herein relate to current sensors and, more particularly to fluxgate current sensor measurement. Some example embodiments are directed to fluxgate current sensor under alternating current (AC) operation.

In accordance with one aspect of the present disclosure, a method for measure current using a fluxgate sensor is provided. In some embodiments, the method include receiving, by a controller, a fluxgate signal corresponding to a primary current, wherein the fluxgate signal comprises at least two plateau periods and each plateau period defines a plurality of candidate calculation windows; generating, by the controller, an operation condition classification based on a signal characteristics set by applying the signal characteristics set to a classification model, wherein the operation condition classification is one of (i) an AC operation condition indicative of AC primary current or (ii) DC operation condition indicative of DC primary current; selecting, by the controller, a calculation window from a plurality of calculation windows based on the operation condition classification, wherein the plurality of calculation windows comprises a first calculation window and a second calculation window; and generating, by the controller, a predicted current value for the primary current by applying sampled current values within the selected calculation window for each of the at least two plateau periods to a prediction model, wherein the generating the predicted current value comprises generating an average of the sampled current values.

In some embodiments, the fluxgate signal is received from a fluxgate excitation and sampling module.

In some embodiments, the method further includes generating the signal characteristics set based on the fluxgate signal by performing analytics on the fluxgate signal.

In some embodiments, the signal characteristics set comprises (i) peak signal data, (ii) signal variance data, and (iii) cycle data.

In some embodiments, generating the operation condition classification comprises determining: (i) whether the peak signal data satisfies a peak threshold value (ii) whether the variance data satisfies a variance threshold value, and (iii) whether the cycle data satisfies a cycle threshold.

In some embodiments, generating the operation condition classification further comprises generating the operation condition classification as a DC operation condition classification in response to determining that (i) the peak signal data fails to satisfy the peak threshold value and (ii) the variance data fails to satisfy the variance threshold value.

In some embodiments, generating the operation condition classification further comprises generating the operation condition classification as an AC operation condition classification in response to determining that (i) the peak signal data satisfies the peak threshold value or (ii) the variance data satisfies the variance threshold value.

In some embodiments, the classification model is a rules-based model that comprises a plurality of rules, wherein generating the operation condition classification comprises comparing the signal characteristics set to one or more thresholds.

In some embodiments, selecting the calculation window from the plurality of calculation windows based on the operation condition classification comprises selecting the first calculation window in response to a DC operation condition classification, wherein the first calculation window has a length that is less than a length of each of the at least two plateau periods.

In some embodiments, selecting the calculation window from the plurality of calculation windows based on the operation condition classification comprises selecting the second calculation window in response to an AC operation condition classification.

**BRIEF DESCRIPTION OF THE DRAWINGS**

The description of the illustrative embodiments may be read in conjunction with the accompanying figures. It will be appreciated that, for simplicity and clarity of illustration, elements illustrated in the figures have not necessarily been drawn to scale, unless described otherwise. For example, the dimensions of some of the elements may be exaggerated relative to other elements, unless described otherwise. Embodiments incorporating teachings of the present disclosure are shown and described with respect to the figures presented herein, in which:

FIG. 1 provides a block diagram of an example fluxgate current sensor in accordance with at least one embodiment of the present disclosure.
FIG. 2. provides an example fluxgate signal waveform for a primary current in accordance with at least one example embodiment of the present disclosure.

FIG. 3. provides an example fluxgate signal waveform comparison plot in accordance with at least one example embodiment of the present disclosure.

FIG. 4 provides a flow chart depicting operations of an example method for measuring current using a fluxgate current sensor in accordance with at least on embodiment of the present disclosure.

FIG. 5 provides example fluxgate signals with different frequencies in accordance with at least one example embodiment of the present disclosure.

## DETAILED DESCRIPTION OF THE INVENTION

Some embodiments of the present disclosure will now be described more fully hereinafter with reference to the accompanying drawings, in which some, but not all embodiments of the disclosure are shown. Indeed, these disclosures may be embodied in many different forms and should not be construed as limited to the embodiments set forth herein; rather, these embodiments are provided so that this disclosure will satisfy applicable legal requirements. Like numbers refer to like elements throughout.

Terms such as "computing," "determining," "generating," and/or similar words are used herein interchangeably to refer to the creation, modification, or identification of data. Further, "based on," "based on in part on," "based at least on," "based upon," and/or similar words are used herein interchangeably in an open-ended manner such that they do not indicate being based only on or based solely on the referenced element or elements unless so indicated. Like numbers refer to like elements throughout.

As used herein, terms such as "front," "rear," "top," etc. are used for explanatory purposes in the examples provided below to describe the relative position of certain components or portions of components. Furthermore, as would be evident to one of ordinary skill in the art in light of the present disclosure, the terms "substantially" and "approximately" indicate that the referenced element or associated description is accurate to within applicable engineering tolerances.

As used herein, the term "comprising" means including but not limited to and should be interpreted in the manner it is typically used in the patent context. Use of broader terms such as comprises, includes, and having should be understood to provide support for narrower terms such as consisting of, consisting essentially of, and comprised substantially of.

The phrases "in one embodiment," "according to one embodiment," and the like generally mean that the particular feature, structure, or characteristic following the phrase may be included in at least one embodiment of the present disclosure, and may be included in more than one embodiment of the present disclosure (importantly, such phrases do not necessarily refer to the same embodiment).

The word "example" or "exemplary" is used herein to mean "serving as an example, instance, or illustration." Any implementation described herein as "exemplary" is not necessarily to be construed as preferred or advantageous over other implementations.

If the specification states a component or feature "may," "can," "could," "should," "would," "preferably," "possibly," "typically," "optionally," "for example," "often," or "might" (or other such language) be included or have a characteristic, that a specific component or feature is not required to be included or to have the characteristic. Such a component or feature may be optionally included in some embodiments, or it may be excluded.

As used herein, the term "or" is used in both the alternative and conjunctive sense, unless otherwise indicated. The terms "illustrative" and "example" are used to be examples with no indication of quality level. Terms such as "computing," "determining," "generating," and/or similar words are used herein interchangeably to refer to the creation, modification, or identification of data. Further, "based on," "based on in part on," "based at least on," "based upon," and/or similar words are used herein interchangeably in an open-ended manner such that they do not indicate being based only on or based solely on the referenced element or elements unless so indicated. Like numbers refer to like elements throughout.

Fluxgate is a current sensing technology, which can be used in various current measurement applications, including current measurement in electrical vehicle (EV) and energy storage system (ESS). A fluxgate current sensor may be used to measure direct current (DC) and/or alternating current (AC). For example, many applications may include DC primary current and AC primary current that need to be measured. For example, many electrical vehicles include DC primary currents such as DC charging and discharging as well as AC primary currents such as PTC, charging AC harmonics, and/or the like. Such complex application scenarios, for example, may require that the battery pack current sensor (e.g., in electrical vehicles or other devices/systems) not only accurately measure the direct current, but also accurately detect the AC primary current. Accordingly, there is a need for a robust current sensing capable of accurately measuring both DC primary current and AC primary current.

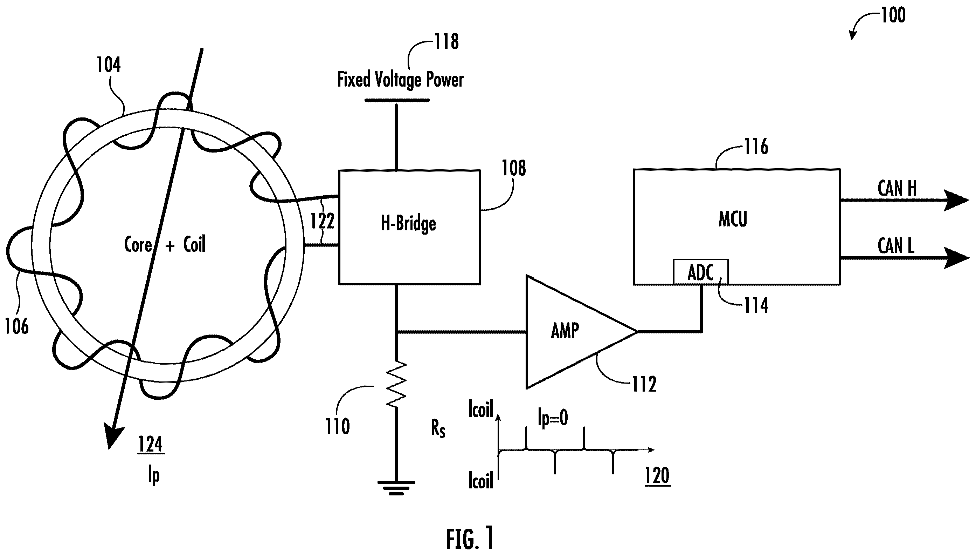

FIG. 1 is a block diagram of an example fluxgate current sensor 100 in accordance with at least one embodiment of the present disclosure. As shown in FIG. 1, the fluxgate current sensor 100 comprises a magnetic core 104, a coil 106, a fluxgate oscillation circuit 108, a sampling resistor 110, an amplifier 112, an analog-to-digital converter (ADC) 114, and a controller 116. In some embodiments, the fluxgate oscillation circuit 108, sampling resistor 110, amplifier 112, and/or an ADC 114 may collectively define a fluxgate excitation and sampling module of the fluxgate current sensor 100. For example, a fluxgate excitation and sampling module of the fluxgate current sensor 100 may include a fluxgate oscillation circuit 108, sampling resistor 110, amplifier 112, and/or an ADC 114.

The magnetic core 104 may be circular, such as, for example, example, a circular toroid. The coil 106 is wound around the magnetic core 104 and includes two ends 122 connected to the fluxgate oscillation circuit 108. The fluxgate oscillation circuit 108 is also connected to the sampling resistor 110. In this regard, the coil 106 is connected to the sampling resistor 110. In some embodiments and as shown in FIG. 1, the coil 106 is connected in series with the sampling resistor. The sampling resistor 110, for example, may be a low resistance resistor connected in series to the fluxgate oscillation circuit 108. The fluxgate oscillation circuit 108 circulates the coil 106 (e.g., forward and backward) to create an excitation signal on the coil 106, thereby generating an excitation current in the coil 106, such as a periodic signal.

In some embodiments, the fluxgate oscillation circuit 108 comprises an H-bridge circuit configured to generate the periodic excitation signal. The characteristics of the excitation signal, such as the oscillation period and platform amplitude of the excitation signal may be affected by the voltage (e.g., drive voltage) from the power supply 118, the magnitude of the primary current 124, and/or the inductance of the coil 106.

In various embodiments, the excitation signal on the coil 106 (e.g., corresponding to excitation current on the coil 106) is sampled and the sampled excitation signal is processed (e.g., signal processing) in order to measure the current value of the primary current 124. In various embodiments, sampling and processing the excitation signal comprises sampling and processing the voltage signal 120 of the sampling resistor 110. For example, the voltage signal 120 of the sampling resistor 110 may correspond to the excitation signal. As described above, the sampling resistor 110 is connected in series with the sampling resistor 110 in some embodiments, thus, the current flowing through the sampling resistor 110 is the same as the current flowing through the coil 106. In this regard, in some embodiments, the fluxgate current sensor 100 detects the voltage signal 120 of the sampling resistor 110 (e.g., based on the characteristic of easy saturation inductance) and processes the voltage signal 120 so as to determine the current value of the primary current 124, The sampled signal may be referred to herein as the fluxgate signal.

In various embodiments, the amplifier 112 is configured to amplify the voltage signal 120 of the sampling resistor 110. For example, processing the excitation signal may comprise the amplifier 112 receiving the voltage signal 120 and outputting amplified voltage signal 120 (referred to herein, interchangeably, as fluxgate signal) to the controller 116. As shown, in FIG. 1, the amplifier 112 may output the amplified voltage signal 120 to the controller 116 through the ADC 114. In some embodiments, the controller 116 is configured to calculate the current value of the primary current 124 (e.g., the current to be measured). In some embodiments, the controller 116 is a microcontroller.

In some embodiments, the controller 116 includes a processor, memory, input/output circuitry, and/or communications circuitry, to execute and perform one more operations described herein with respect to the fluxgate current sensor 100. For example, the controller 116 may include a set of circuitry, which may include a processor, memory, input/output circuitry, and/or communications circuitry. For example, the controller 116 may include a processor configured to process the signal output by the ADC 114, including calculating the current value of the primary current 124. In some embodiments, the memory is configured to store software and/or firmware configured to provide instructions, such as computer instructions or computer code, in conjunction with the processor and other circuitries to process the signal output by the ADC 114, including calculating the current value of the primary current 124. In some embodiments, the controller 116 may communicate with other devices using the communications circuitry. By way of example, the communications circuitry includes one or more communication components that enable communication between the fluxgate current sensor 100 (e.g., controller 116 thereof) and other device. By way of non-limiting example, the one or more communication components may comprise controller area network (CAN) bus that enable communication between the fluxgate current sensor 100 (e.g., controller 116 thereof) and other devices. The controller 116, for example, may comprise a CAN bus (e.g., comprising a CAN low and/or a CAN high) that enables communication with other devices.

In some embodiments, the term circuitry includes hardware and, in some embodiments, software for configuring the hardware. For example, in some embodiments, circuitry includes processing circuitry, storage media, network interfaces, input/output devices, and/or the like. Alternatively or additionally, in some embodiments, other elements of the controller 116 provide or supplement the functionality of another particular set of circuitry. For example, the processor in some embodiments provides processing functionality to any of the sets of circuitry, the memory provides storage functionality to any of the sets of circuitry, the communications circuitry provides network interface functionality to any of the sets of circuitry, and/or the like.

In some embodiments, the controller 116 may be embodied as one or more complex programmable logic devices (CPLDs), microprocessors, multi-core processors, coprocessing entities, application-specific instruction-set processors (ASIPs), and/or microcontrollers. In some embodiments, the controller 116 may be embodied as integrated circuits, application specific integrated circuits (ASICS), field programmable gate arrays (FPGAs), programmable logic arrays (PLAs), hardware accelerators, digital circuitry, and/or the like.

In some embodiments, the fluxgate current sensor 100 and/or a portion thereof may be embodied by one or more system(s) and/or apparatus(es).

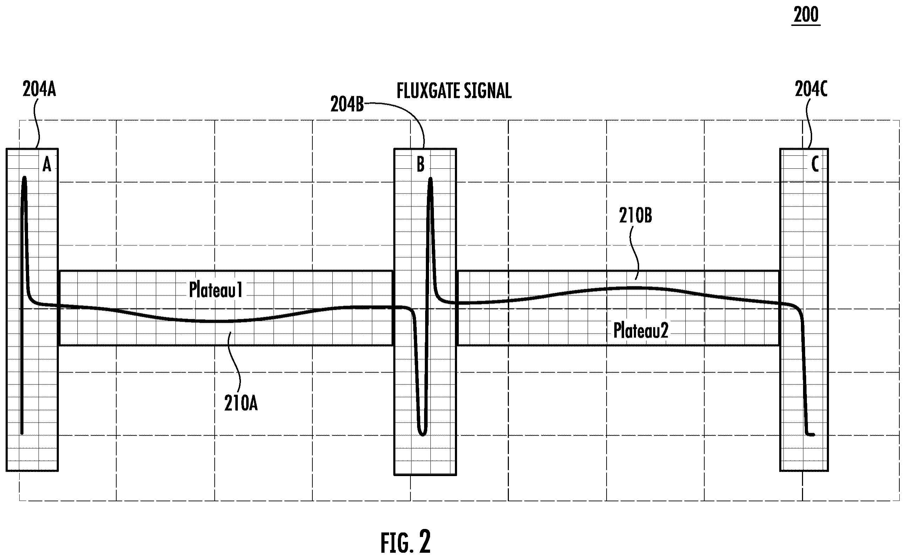

FIG. 2. provides an example fluxgate signal waveform 200 for a current to be measured in accordance with at least one example embodiment of the present disclosure. In particular, FIG. 2 provides an example acquisition period of the fluxgate signal (e.g., reflective of the excitation current on the coil 106) generated by fluxgate oscillation circuit 108. The fluxgate signal waveform 200 (e.g., an acquisition period of the fluxgate signal) may include saturation-desaturation regions(s) (e.g., at least one saturation and desaturation regions) and plateau period(s). As shown, in FIG. 2, in some embodiments, the fluxgate signal waveform 200 includes at least three saturation-desaturation regions 204A-C (e.g., unstable regions) and at least two plateau periods 210A, 210B. For example, an acquisition period of the fluxgate signal represented in the fluxgate signal waveform may include a first saturation-desaturation regions 204A, a second saturation-desaturation region 204B, and a third saturation-desaturation region 204C. Additionally, the fluxgate signal waveform 200 (e.g., acquisition period of the fluxgate signal represented therein) may include a first plateau period 210A and a second plateau period 210B. In some examples, the amplitudes of the first plateau period 210A and/or the second plateau period 210B may vary.

In some embodiments, a plateau period (such as plateau periods 210A, 210B) is a region between two consecutive saturation-desaturation regions (e.g., between 204A and 204B, between 204B and 204C). A plateau period may have a predetermined length. In some embodiments, the length of a plateau period may be reflective of a region within the acquisition period of the fluxgate signal that is substantially stable.

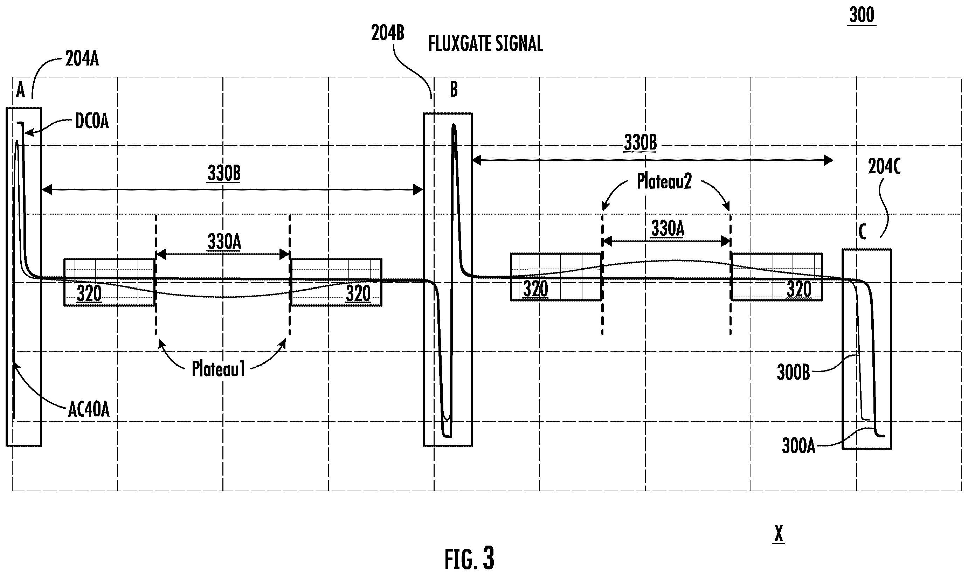

FIG. 3. provides an example fluxgate signal waveform comparison plot 300 in accordance with at least one example embodiment of the present disclosure. In particular, FIG. 3 shows an example fluxgate signal waveform 300A for a DC current type and an example fluxgate signal waveform 300B for an AC current type. Such fluxgate signal waveform 300A may be referred to herein as DC fluxgate signal waveform 300A. The fluxgate signal waveform 300A represents an acquisition period of a first fluxgate signal corresponding to the DC current and the fluxgate signal waveform 300B represents an acquisition period of a second fluxgate signal corresponding to the AC current. Such fluxgate signal waveform 300B may be referred to herein as AC fluxgate signal waveform 300B.

In some embodiments, a plateau period defines a plurality of calculation windows (e.g., plurality of candidate calculation windows). In some embodiments, the plurality of calculation windows include a first calculation window such as, for example, first calculation window 330A and a second calculation window 330B. In some embodiments, and as shown in FIG. 3, the first calculation window 330A has a length that is less than the length of a plateau period and the second calculation window 330B has a length that is substantially the same as the length of the plateau periods. In this regard, the first calculation window 330A has a length that is less relative to the length of the second calculation window.

In some embodiments, the controller 116 is configured to determine the operation condition associated with the fluxgate current sensor 100 and select a calculation window from the plurality of calculation windows based on operation condition. In some embodiments, the operation condition refers to the primary current signal type (e.g., DC primary current or AC primary current) of the current that is being measured. For example, DC operation condition may be indicative of a DC primary current signal and AC operation condition may be indicative of an AC primary current signal.

In some embodiments, the controller 116 is configured to select the first calculation window in response to determining that the signal is an interference signal. In some embodiments, the controller 116 is configured to select the first calculation window in response to determining that the operation condition is a DC operation condition and select a second calculation window in response to determining that the operation condition is an AC operation condition. For instance, the fluxgate signal (e.g., sampling values thereof) may change minimally during the plateau periods 210A, 210B of the DC fluxgate signal waveform 300A such that the length of the calculation window has little to no significant influence on the calculated current value when the primary current signal is a DC primary current. For instance, during the plateau periods 210A, 210B for a DC fluxgate signal waveform 300A, the interference signal may be coupled to the saturation-desaturation regions 204A-C (e.g., indicative of unstable regions). Further, anti-interference may be improved for a DC operation condition with a short calculation window without affecting the accuracy of the calculated current value (e.g., the calculated value of primary current).

On the other hand, the fluxgate signal may change significantly during the plateau periods 210A, 210B of the AC fluxgate signal waveform 300B, such that the calculation window has significant influence on the calculated current value. For example, a calculation window that excludes the regions 320 within a plateau period may result in inaccurate calculated current value. For example, the average of the signals in the regions 320 would not be included in the calculated current value, thus the signal variation in the regions 320 would not be reflected in the calculated current value and the accuracy of the calculated current value would be affected.

In some embodiments, the controller 116 determines the operation condition classification using a classification model and based on signal characteristics set. In some embodiments, the classification model is a rules-based model. For example, in some embodiments, the classification model includes a set of rules. Each rule may include one or more rule conditions defined at least in part by one or more characteristics of the fluxgate signal within a plateau period (and/or associated platform period) and corresponding thresholds.

In some embodiments, the controller 116 generates the signal characteristics set by performing analytics on the fluxgate signal. In some embodiments, performing analytics on the fluxgate signal comprises extracting data from the fluxgate signal and analyzing and/or processing the extracted data. In some embodiments, the fluxgate signal and/or extracted data may be applied to one or more analytical models to generate the signal characteristics set. In some embodiments, the analytical models may comprise one or more mathematical models.

In some embodiments, the signal characteristics set comprises peak signal data, signal variance data, and cycle data. In some embodiments, the peak signal data includes peak values for the first and/or second plateau periods (e.g., peak value P1 in the first plateau period 210A and/or peak value P2 in the second plateau period 210B). In some embodiments, the signal variance data includes variance values for the first and/or second plateau periods (e.g., variance V1 in the first plateau period 210A and/or variance V2 in the second plateau period 210B). In some embodiments, the cycle data includes the number of cycles for the first and/or second plateau periods (e.g., number of signal cycles in the first plateau period 210A and/or number of signal cycles C2 in the second plateau period 210B.

For example, the peak value of DC fluxgate signal within the plateau periods 210A, 210B may be small relative to the peak value of AC fluxgate signal within the plateau periods 210A, 210B and conversely, the peak value of AC fluxgate signal within the plateau periods 210A, 210B may be large relative to the peak value of DC fluxgate signal within the plateau periods 210A, 210B. Further, the variance (e.g., a measure of variation) of DC fluxgate signal within the plateau periods 210A, 210B may be small relative to the peak value of AC fluxgate signal within the plateau periods 210A, 210B and conversely, the variance of AC fluxgate signal within the plateau periods 210A, 210B may be large relative to the variance of DC fluxgate signal within the plateau periods 210A, 210B. Further, the amplitude of AC fluxgate signal (e.g., AC sampled signal) may change periodically, and the number of cycles per unit length platform period may correspond to the signal period of the primary side.

In some embodiments, the one or more rule conditions include a first condition that evaluates the peak value (P1, P2) of each of the first plateau period 210A and second plateau period 210B against a threshold P to determine if the respective peak value is greater that the threshold P. In some embodiments, the one or more rule conditions include a second condition that evaluates the variance value (V1, V2) of each of the first plateau period 210A and second plateau period 210B against a threshold V to determine if the variance is greater that the threshold V. In some embodiments, the one or more rule conditions include a third condition that evaluates the cycle data (C1, C2) of each of the first plateau period 210A and plateau period 210B against a threshold C to determine if the cycle data is greater that the threshold C.

In some embodiments, the controller 116 (e.g., using the classification model) is configured to determine that the fluxgate signal is an interference signal in response to determining that at least two of the rule conditions are satisfied. For example, the fluxgate signal may be asymmetric when at least two of the rule conditions are satisfied indicative of an interference signal. In some embodiments, the controller 116 (e.g., using the classification model) is configured to determine that fluxgate signal is a stable signal in response to determining that none of the rule conditions are met.

In some embodiments, the controller 116 (e.g., using the classification model) is configured to generate a DC operation classification (e.g., classify the operation condition as DC operation condition) in response to determining that each of the first condition and second condition is not satisfied. For example, the controller may determine that the operation condition is DC operation condition (e.g., indicative of DC primary signal) in response to determining that the peak value during the plateau period (e.g., first and/or second plateau period) is less than the corresponding peak threshold and the variance during the plateau period (e.g., first and/or second plateau period) is less than the corresponding variance threshold. In some embodiments, the controller 116 may be configured to first determine if the fluxgate signal is stable before generating the DC operation classification.

In some embodiments, the controller 116 (e.g., using the classification model) is configured to generate an AC operation condition classification (e.g., classify the operation condition as AC operation condition) in response to determining that at least one of the first condition or the second condition is satisfied. For example, the controller 116 may determine that the operation condition is AC operation condition (e.g., indicative of AC primary signal) in response to determining that the peak value during the plateau period (e.g., first and/or second plateau period) is greater than the corresponding peak threshold or the variance during the plateau period (e.g., first and/or second plateau period) is greater than the corresponding variance threshold.

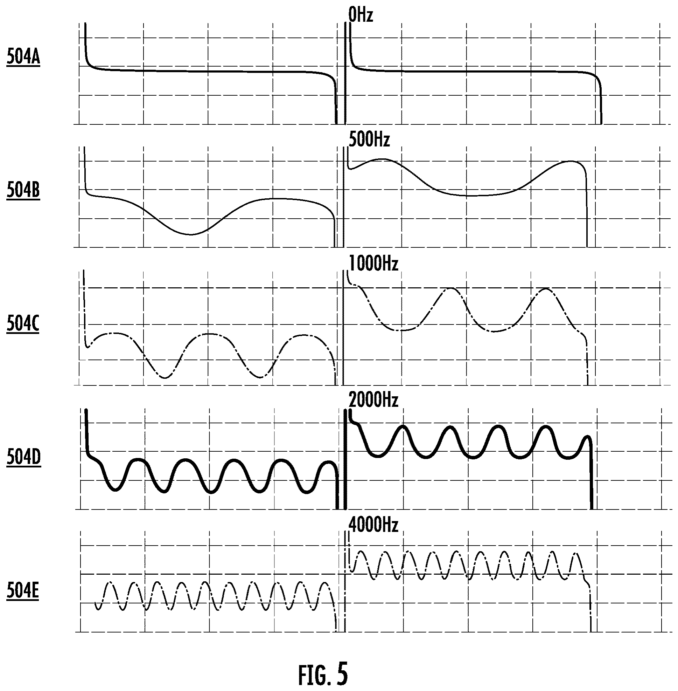

In some embodiments, in order to avoid accidental fluctuations that may affect the operation condition classification, a predetermined minimum number of sampling times to switch between DC and AC operation conditions is accumulated. As shown in FIG. 5, for example, a plurality of signals 504A-E at different frequencies may be leveraged.

In some embodiments, the controller 116 is configured to calculate the value of the primary current by performing the operation in equation 1 below:

$$I_p = K * \left( \frac{\sum Plateau1}{Count_{Plateau1}} - \frac{\sum Plateau2}{Count_{Plateau2}} \right)$$

## Equation 1

In the equation 1, $I_p$ may represent the calculated current value for the primary current; $\frac{\sum Plateau1}{Count_{Plateau1}}$ may represent the average current value in the selected calculation window of the first plateau period 210A; $\sum Plateau1$ may represent the sum of the sampled current values in the selected calculation window of the first plateau period; $Count_{Plateau1}$ may represent the size of the calculation window during the platform period associated with the first plateau period; $\frac{\sum Plateau2}{Count_{Plateau2}}$ may represent the average current value in the selected calculation window of the second plateau period 210B; $\sum Plateau2$ may represent the sum of the sampled current values in the selected calculation window of the first plateau period; and $Count_{Plateau2}$ may represent the size of the calculation window during the platform period associated with the second plateau period.

In some embodiments, the controller 116 is configured to calculate the $Count_{Plateau1}$ by performing the operation in equation 2 below and calculate the $Count_{Plateau2}$ by performing the operation in equation 3 below.

$$Count_{Plateau1} = Ratio * Plateau1Length$$

## Equation 2

$$Count_{Plateau2} = Ratio * Plateau2Length$$

## Equation 3

In the equation 2 and 3 above, $Count_{Plateau1}$ and $Count_{Plateau2}$ may each represent, respectively, the calculation window during the platform period associated with the first plateau and the calculation window during the platform period associated with the second plateau. In some embodiments, the Ratio in equations 2 and 3 above is constant for DC primary current. In some embodiments, the controller 116 is configured to calculate the Ratio in equations 2 and 3 for AC primary current by performing the operation in equation 4 below.

$$Ratio = a * \frac{(C_1 + C_2)}{2} + b;$$

## Equation 4

Where a may represent the gain; b may represent offset; $C_1$ may represent the number of cycles per unit length platform period associated with the first plateau period and corresponding to the signal cycle of the primary current; and $C_2$ may represent the number of cycles per unit length platform period associated with the second plateau period and corresponding to the signal cycle of the primary current. For example, the plateau under AC operation condition (e.g., under AC signal) may be dynamically adjusted with the signal cycles of the primary current.

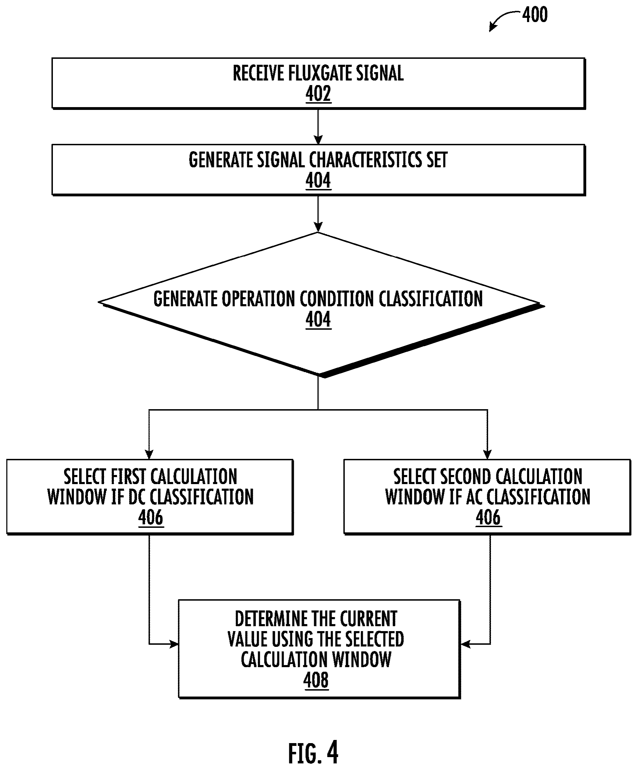

FIG. 4 illustrates a flow chart depicting operations of an example method for measuring current using a fluxgate current sensor in accordance with at least on embodiment. Specifically FIG. 4 depicts an example method 400 for improved fluxgate current sensor under AC operation condition. In some embodiments, the method 400 is performed by one or more specially-configured computing devices, such as an apparatus embodying the fluxgate current sensor alone or in communication with one or more other component(s), device(s), system(s), and/or the like. In some embodiments, the apparatus comprises the fluxgate current sensor 100. In some embodiments, the apparatus is in communication with one or more external apparatus(es), system(s), device(s), and/or the like, to perform one or more of the operations as depicted and described.

Although the example method 400 depicts a particular sequence of operations, the sequence may be altered without departing from the scope of the present disclosure. For example, some of the operations depicted may be performed in parallel or in a different sequence that does not materially affect the function of the method 400. In other examples, different components of an example device or system that implements the method 400 may perform functions at substantially the same time or in a specific sequence.

According to some examples, the method 400 includes receiving a fluxgate signal at block 402. For example, the controller 116 may receive a fluxgate signal from the fluxgate excitation and sampling module of the fluxgate current sensor 100. The fluxgate excitation and sampling module may comprise a fluxgate oscillation circuit (e.g., an H-bridge, or the like), a sampling resistor, an amplifier, and/or an ADC. The fluxgate signal may correspond to a primary current and may comprise at least two plateau periods. Each plateau period of the at least two plateau periods may define a plurality of candidate calculation windows. In some embodiments, a calculation window refers to a portion of the fluxgate signal that includes sampled signals (e.g., representative of sampled current).

According to some examples, the method 400 includes generating a signal characteristics set at block 404. For example, the controller 116 may generate a signal characteristics set based on the fluxgate signal by performing analytics on the fluxgate signal. In some embodiments, performing analytics on the fluxgate signal comprises extracting data from the fluxgate signal and analyzing and/or processing the extracted data. In some embodiments, the fluxgate signal and/or extracted data may be applied to one or more analytical models to generate the signal characteristics set. In some embodiments, the analytical models may comprise one or more mathematical models.

In some embodiments, the signal characteristics set comprises peak signal data, signal variance data, and cycle data. In some embodiments, the signal characteristics set comprises peak signal data, signal variance data, and cycle data. In some embodiments, the peak signal data includes peak values for the first and second plateau periods (e.g., peak value P1 in the first plateau period and/or peak value P2 in the second plateau period). In some embodiments, the signal variance data includes variance values for the first second plateau periods (e.g., variance V1 in the first plateau period and/or variance V2 in the second plateau period). In some embodiments, the cycle data includes the number of cycles for the first and second plateau periods (e.g., number of signal cycles in the first plateau period and/or number of signal cycles C2 in the second plateau period.

According to some examples, the method 400 includes generating an operation condition classification at block 404. For example, the controller 116 may generate an operation condition classification based on a signal characteristics set by applying the signal characteristics set to a classification model. In some embodiments, the operation condition is one of an AC operation condition indicative of AC primary current or a DC operation condition indicative of DC primary current. In some embodiments, the classification model is a rules-based model that comprises a plurality of rules. In some embodiments, generating the operation condition classification comprises comparing the signal characteristics set to one or more thresholds.

In some embodiments, generating the operation condition classification comprises determining: (i) whether the peak signal data satisfies a peak threshold value (ii) whether the variance data satisfies a variance threshold value, and/or (iii) whether the cycle data satisfies a cycle threshold. In some embodiments, generating the operation condition classification includes generating the operation condition classification as a DC operation condition classification in response to determining that (i) the peak value data fails to satisfy the peak threshold value and (ii) the variance data fails to satisfy a variance threshold value. In some embodiments, generating the operation condition classification includes generating the operation condition classification as an AC operation condition classification in response to determining that (i) the peak value data satisfies a peak threshold value or (ii) the variance data satisfies a variance threshold value.

In some embodiments, the peak signal data fails to satisfy the peak threshold value when the peak value during the plateau period (e.g., first and/or second plateau period) is less than the corresponding peak threshold. In some embodiments, variance data fails to satisfy the variance threshold value when the variance during the plateau period (e.g., first and/or second plateau period) is less than the corresponding variance threshold.

In some embodiments, the peak signal data satisfies the peak threshold value when the peak value during the plateau period (e.g., first and/or second plateau period) is greater than the corresponding peak threshold. In some embodiments, variance data satisfies the variance threshold value when the variance during the plateau period (e.g., first and/or second plateau period) is greater than the corresponding variance threshold.

According to some examples, the method 400 includes selecting a calculation window at block 406. For example, the controller 116 may select a calculation window from a plurality of calculation windows based on the operation condition classification. For example, the calculation window may be dynamically changed according to different operation conditions. In some embodiments, the plurality of calculation windows comprise a first calculation window and a second calculation window. In some embodiments, selecting the calculation window from the plurality of calculation windows based on the operation condition classification comprises selecting the first calculation window in response to a DC operation condition classification. In some embodiments, selecting the calculation window from the plurality of calculation windows based on the operation condition classification comprises selecting a second calculation window in response to an AC operation condition classification. In some embodiments, the first calculation window has a length that is less that a length of the second calculation window. In some embodiments, the first calculation window has a length that is less than a length of each of the at least two plateau periods.

According to some examples, the method 400 includes generating a predicted current value for the primary current at block 408. For example, the controller 116 may generate a predicted current value for the primary current by applying the sampled current values within the selected calculation window for each of the at least two plateau periods to a prediction model. In some embodiments, generating the predicted current value comprises generating an average of the sampled current values. For example, the controller 116 may perform the operations shown in equation 1 above. In some embodiments, the prediction model may define the operations in equation 1.

## CONCLUSION

Many modifications and other embodiments of the disclosure set forth herein will come to mind to one skilled in the art to which this disclosure pertains having the benefit of the teachings presented in the foregoing description and the associated drawings. Therefore, it is to be understood that the embodiments are not to be limited to the specific embodiments disclosed and that modifications and other embodiments are intended to be included within the scope of the appended claims. Moreover, although the foregoing descriptions and the associated drawings describe example embodiments in the context of certain example combinations of elements and/or functions, it should be appreciated that different combinations of elements and/or functions may be provided by alternative embodiments without departing from the scope of the appended claims. In this regard, for example, different combinations of elements and/or functions than those explicitly described above are also contemplated as may be set forth in some of the appended claims. Although specific terms are employed herein, they are used in a generic and descriptive sense only and not for purposes of limitation.

While this specification contains many specific implementation details, these should not be construed as limitations on the scope of any disclosures or of what may be claimed, but rather as descriptions of features specific to particular embodiments of particular disclosures. Certain features that are described herein in the context of separate embodiments can also be implemented in combination in a single embodiment. Conversely, various features that are described in the context of a single embodiment can also be implemented in multiple embodiments separately or in any suitable subcombination. Moreover, although features may be described above as acting in certain combinations and even initially claimed as such, one or more features from a claimed combination can in some cases be excised from the combination, and the claimed combination may be directed to a subcombination or variation of a subcombination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single product or packaged into multiple products.

Thus, particular embodiments of the subject matter have been described. Other embodiments are within the scope of the following claims. In some cases, the actions recited in the claims can be performed in a different order and still achieve desirable results. In addition, the processes depicted in the accompanying figures do not necessarily require the particular order shown, or sequential order, to achieve desirable results. In certain implementations, multitasking and parallel processing may be advantageous.

Further, while this detailed description has set forth some embodiments of the present disclosure, the appended claims may cover other embodiments of the present disclosure which differ from the described embodiments according to various modifications and improvements. Further, within the appended claims, unless the specific terms "means for" or "step for" is used within a given claim, it is not intended that the claim be interpreted under 35 U.S.C. § 112, paragraph (f).

## Claims

1. A method of measuring current using a fluxgate current sensor, the method comprising:

   receiving, by a controller, a fluxgate signal corresponding to a primary current, wherein the fluxgate signal comprises at least two plateau periods and each plateau period defines a plurality of candidate calculation windows;
   generating, by the controller, an operation condition classification based on a signal characteristics set by applying the signal characteristics set to a classification model, wherein the operation condition classification is one of (i) an AC operation condition indicative of AC primary current or (ii) DC operation condition indicative of DC primary current;
   selecting, by the controller, a calculation window from a plurality of calculation windows based on the operation condition classification, wherein the plurality of calculation windows comprises a first calculation window and a second calculation window; and
   generating, by the controller, a predicted current value for the primary current by applying sampled current values within the selected calculation window for each of the at least two plateau periods to a prediction model, wherein the generating the predicted current value comprises generating an average of the sampled current values.

2. The method of claim 1, wherein the fluxgate signal is received from a fluxgate excitation and sampling module.

3. The method of claim 1, further comprising generating the signal characteristics set based on the fluxgate signal by performing analytics on the fluxgate signal.

4. The method of claim 3, wherein the signal characteristics set comprises (i) peak signal data, (ii) signal variance data, and (iii) cycle data.

5. The method of claim 4, wherein generating the operation condition classification comprises determining: (i) whether the peak signal data satisfies a peak threshold value (ii) whether the variance data satisfies a variance threshold value, and (iii) whether the cycle data satisfies a cycle threshold.

6. The method of claim 5, wherein generating the operation condition classification further comprises generating the operation condition classification as a DC operation condition classification in response to determining that (i) the peak signal data fails to satisfy the peak threshold value and (ii) the variance data fails to satisfy the variance threshold value.

7. The method of claim 5, wherein generating the operation condition classification further comprises generating the operation condition classification as an AC operation condition classification in response to determining that (i) the peak signal data satisfies the peak threshold value or (ii) the variance data satisfies the variance threshold value.

8. The method of claim 1, wherein the classification model is a rules-based model that comprises a plurality of rules, wherein generating the operation condition classification comprises comparing the signal characteristics set to one or more thresholds.

9. The method of claim 1, wherein selecting the calculation window from the plurality of calculation windows based on the operation condition classification comprises selecting the first calculation window in response to a DC operation condition classification, wherein the first calculation window has a length that is less than a length of each of the at least two plateau periods.

10. The method of claim 1, wherein selecting the calculation window from the plurality of calculation windows based on the operation condition classification comprises selecting the second calculation window in response to an AC operation condition classification.

FIG. 1

EP 4 741 839 A1

FIG. 2

FIG. 3

400

```
┌─────────────────────────────────────────────┐
│           RECEIVE FLUXGATE SIGNAL             │
│                     402                       │
└─────────────────────────────────────────────┘
                      │
                      ▼
┌─────────────────────────────────────────────┐
│        GENERATE SIGNAL CHARACTERISTICS SET    │
│                     404                       │
└─────────────────────────────────────────────┘
                      │
                      ▼
        ╱─────────────────────────────╲
      ╱   GENERATE OPERATION CONDITION   ╲
     ╱         CLASSIFICATION             ╲
      ╲            404                    ╱
        ╲─────────────────────────────╱
          │                         │
          ▼                         ▼
┌──────────────────────┐  ┌──────────────────────┐
│  SELECT FIRST         │  │  SELECT SECOND        │
│  CALCULATION          │  │  CALCULATION          │
│  WINDOW IF DC         │  │  WINDOW IF AC         │
│  CLASSIFICATION       │  │  CLASSIFICATION       │
│       406             │  │       406             │
└──────────────────────┘  └──────────────────────┘
          │                         │
          │    ┌──────────────────┐ │
          └───▶│  DETERMINE THE    │◀┘
               │  CURRENT VALUE    │
               │  USING THE        │
               │  SELECTED         │
               │  CALCULATION      │
               │  WINDOW           │
               │       408         │
               └──────────────────┘
```

FIG. 4

504A

0Hz

504B

500Hz

504C

1000Hz

504D

2000Hz

504E

4000Hz

FIG. 5

Europäisches
Patentamt
European
Patent Office
Office européen
des brevets

# EUROPEAN SEARCH REPORT

**Application Number**

EP 25 20 5562

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WO 2015/070345 A1 (UNIV MANITOBA [CA]) 21 May 2015 (2015-05-21) * the whole document * | 1-10 | INV. G01R15/18 ADD. G01R19/20 |
| A | YANG XIAOGUANG ET AL: "A New Compact Fluxgate Current Sensor for AC and DC Application", IEEE TRANSACTIONS ON MAGNETICS, IEEE, USA, vol. 50, no. 11, 1 November 2014 (2014-11-01), pages 1-4, XP011566122, ISSN: 0018-9464, DOI: 10.1109/TMAG.2014.2330373 [retrieved on 2014-12-02] * the whole document * | 1-10 | |
| A | CN 114 690 084 A (GEOLOGICAL AND GEOPHYSICAL INST OF CHINESE ACADEMY OF SCIENCES) 1 July 2022 (2022-07-01) * the whole document * | 1-10 | |

**TECHNICAL FIELDS SEARCHED (IPC)**

G01R

The present search report has been drawn up for all claims

| Place of search | Date of completion of the search | Examiner |
|---|---|---|
| Munich | 6 March 2026 | Hijazi, Ali |

EPO FORM 1503 03.82 (P04C01)

## ANNEX TO THE EUROPEAN SEARCH REPORT
## ON EUROPEAN PATENT APPLICATION NO.

EP 25 20 5562

This annex lists the patent family members relating to the patent documents cited in the above-mentioned European search report.
The members are as contained in the European Patent Office EDP file on
The European Patent Office is in no way liable for these particulars which are merely given for the purpose of information.

06-03-2026

| Patent document cited in search report | Publication date | Patent family member(s) | Publication date |
|---|---|---|---|
| WO 2015070345 A1 | 21-05-2015 | NONE | |
| CN 114690084 A | 01-07-2022 | NONE | |

EPO FORM P0459

For more details about this annex : see Official Journal of the European Patent Office, No. 12/82